# EUROPEAN PATENT SPECIFICATION

(11) **EP 3 061 328 B1**
(45) Date of publication and mention of the grant of the patent: **24.04.2019**
(21) Application number: 14787194.1
(22) Date of filing: 24.10.2014
(51) Int. Cl.: H05K 7/14

(54) **AUTOMATICALLY GENERATING A MODEL FOR A DATA CENTRE MANAGEMENT**
AUTOMATISCHE ERZEUGUNG VON EINEM MODELL FÜR EINE DATENZENTRENVERWALTUNG
GÉNÉRATION AUTOMATIQUE D'UN MODÈLE D'UN CENTRE DE DONNÉES

(30) Priority: 24.10.2013 GB 201318779
(43) Date of publication of application: 31.08.2016
(73) Proprietor: Eaton Intelligent Power Limited, 4 Dublin (IE)
(72) Inventor: QUETTE, Arnaud, 38660 Saint-Bernard (FR); BRISSON, Cyrille, 1052 Mont-sur-Lausanne (CH)
(74) Representative: Eaton IP Group EMEA
(86) International application number: PCT/EP2014/072802
(87) International publication number: WO 2015/059255

(56) References cited:
- US-A1- 2005 010 499
- US-A1- 2011 191 454
- US-A1- 2012 005 344

## Description

The present invention refers to a method of automatically generating a model of an arrangement of at least one device arranged in a setting of a data centre, and further to a system for generating a model of at least one device arranged in a setting of a data centre, according to such a method, the system comprising a network, the at least one device being connected to the network, a data storage means capable of storing data and being connected to the network, a processing means capable of processing data and generating an output, the processing means running a central software and being connected to the network, the central software being adapted to access the at least one device and to access an inventory of devices, and a mobile device controller connected to the network.

Data centres are facilities for housing computer systems and various components associated with the computer systems. For example, a typical data centre may include, in addition to computer systems, backup power supplies, backup data communication connections, environmental controls, and security components. With the growth in the use of computers to host business applications, Internet Websites, etc., a need to build bigger data centres to house computers and related hardware has also grown exponentially. Many data centres, also known as "server farms", house thousands of computers and related devices such as networking gears, etc. The devices in a data centre are typically connected via any kind of network. Since the data centre users often critically depend on the continuous availability of their system, special attention is paid to manage data centres, for example, to prevent or minimize server down times. Inventory management of the devices in a data centre plays a critical role in ensuring high availability of computing resources. It is thus unfavourable to maintain a data centre inventory manually. This method of tracking inventory of computing resources is highly inefficient and error-prone, especially for large size data centres.

In US 8 458 329 B2, a data centre inventory management is described, wherein a user interface is accessible on a display, including graphical displays so as to mimic a physical arrangement of racks in the data centre, and of blade hosts in the racks, the display further showing information for each blade host in the plurality of blade hosts. For identification purposes, RFID technology is used, for example, to track moveable devices, like the blade hosts. Each device carries an identifying RFID tag readable by an RFID reader.

It is a drawback of the RFID based solution for identifying the devices in a data centre, as well as of other detection sensor based solutions, that, while manual tasks are minimized, that they are expensive and require a preliminary deployment of the RFID tags or detection sensors.

Further solutions for managing and tracking inventory of computing resources in data centres are known from the following prior art documents:
US 2011/191454 A1 discloses a computing system for discovering a physical location of a physical server device in a datacenter. The computing system obtains at least one physical property of the physical server device pertaining to the physical location of the physical server device. The computing system acquires at least one logical property of the physical server device pertaining to a logical server name of the physical server device. The computing system correlates the at least one physical property and the at least one logical property. Thereby, the computing system matches the logical server name to the physical location.

US 2005/010499 A1 discloses a system for managing inventory of components in a room. The system includes an identification device configured to communicate identification information relating to an associated component, a reader device configured to substantially autonomously receive the identification information from the identification device, and means for identifying the locations of the identification devices. The system also includes a controller configured to communicate with the reader device and compile the identification information received from the reader device and the locations of the identification devices to maintain an inventory of the components.

It is an objective of the present invention, to provide a method and system for generating a model of an arrangement of at least one device arranged in a setting of a data centre, which is less error-prone than manual methods and which does not require a preliminary tagging of the devices or instrumentation of the data centre.

The objective is achieved by a method according to claim 1. Preferred embodiments are subject to the dependent claims.

The method of automatically generating a model of an arrangement of at least one device arranged in a setting of a data centre comprises the steps of
- (a) sending a command to the at least one device upon which command the device emits an identification signal, wherein the identification signal is receivable by a mobile device controller,
- (b) receiving the identification signal,
- (c) recording a visual representation of the arrangement of the at least one device,
- (d) identifying the at least one device according to the identification signal,
- (e) providing the model comprising at least the following information: the identification of the device and the arrangement of the device in the setting.

It is an advantage of the method according to the invention that the devices of a data centre can be automatically located and identified in the respective setting, which allows the generation of a model of the devices in the data centre.

A data centre according to the invention is particularly defined as a location, for example, a room, that houses numerous electronic devices, each device arranged in one of a plurality of settings. Devices according to the invention are computer systems and other related components, for example, network switches, routers, uninterruptible power supplies etc. In a data centre, the devices are housed in receptacles, usually metallic cages, which are typically called racks, with regard to the invention most generally referred to as settings. A standard rack may be defined as an enclosure of standardized dimension. Standard racks are usually configured to house a number of computer system devices, for example, about forty to eighty of such devices. Racks are typically designed to maximize physical space utilization in a data centre room. A rack may include a number of chassis or compartments. Chassis are used to house computer system devices. In some cases, a rack may as well house computer system devices, which are directly installed without a use of a chassis. The model of an arrangement of one or more devices arranged in a setting of a data centre, according to the invention, thus describes a localisation of the different devices inside a rack of a data centre, however, without being limited to the standard racks of computer rooms. The method according to the invention is applicable as well with any other local distribution of devices, of which a visual representation can be recorded, as long as the devices are connected via a network.

Sending a command to the at least one device according to step (a) means, to transmit a signal via the network connecting the devices of the data centre, using a specific network communication protocol. The command is preferably sent from a kind of data centre management device. Providing the model according to step (e) means to produce an output, which may be a printable representation of the data centre's settings with the respective device arrangements therein. Preferably, the model is provided in a data format that can be further processed. More preferably, the model is provided in a data format processible by a data centre management software tool.

Emitting an identification signal upon receipt of the command, which is receivable by a mobile device controller, according to the invention, means a direct transmission of the identification signal from the device to the mobile device controller. The identification signal is not sent via the network. The mobile device controller is thus necessarily located in a vicinity of the respective device to receive the identification signal. The definition of the vicinity of the device, where the identification signal is receivable, depends on the kind of emitter. For electromagnetic emission of the id signal, for example, the range of the emitter will be the significant limiting factor. This may also require intervisibility, i.e. the absence of a shielding barrier between the emitter and the mobile device controller. Preferably, the identification signal is emitted in the form of a visual signal, which particularly includes

According to a preferred embodiment, the steps (b) and (c) are both executed by means of an optical receiver, particularly by means of only one optical receiver. Furthermore preferred is an embodiment, wherein steps (b) and (c) are executed simultaneously.

According to a further preferred embodiment, the identification signal is emitted by light emitting and/or display means of the device. Particularly, the means are lamps, LEDs or displays which are mounted on the devices anyway, like, for example, LEDs for signalling a function of the device or an LCD for showing status information.

According to a further preferred embodiment, the identification of the at least one device is encoded in the identification signal. For example, each device is assigned to emit a visual signal with a specific blinking frequency, which allows an identification of the device. Or each device is assigned to emit the visual signal in the form of a blinking code, which is encoded, for example, with a Morse code etc. For decoding the id signal, in this case, in step (b) a sequence of the id signal is received, for example, in the form of a short video sequence or, more generally speaking, in the form of a sequence of an adequate number of subsequent frames. Preferably, the identification signal received in step (b) is stored and the identification according to step (d) is executed subsequently, on the basis of the stored identification signal.

According to a further preferred embodiment, the identification signal received in step (b) is stored together with a timestamp comprising an information on a reception time of the identification signal. At least a first execution of step (a) is preferably triggered by the mobile device controller, i.e. usually an operator will trigger the first execution of step (a) from the mobile device controller. Furthermore preferably, synchronously with a first execution of step (a), an activity monitoring of the at least one device is started. With the mobile device controller being synchronized to the data centre devices emitting the id signals, it is advantageously possible to store only one freeze frame or photograph of the device, which is received when the device is actually sending the id signal, thus minimizing the necessary data traffic and storage demand.

The identification of the at least one device according to step (d) is preferably executed by matching the timestamp of the stored identification signal with the monitored activity at the reception time of the identification signal.

According to a further preferred embodiment, the model is provided with a graphical representation of the arrangement of the at least one device in the setting on the basis of the recorded visual representation. Furthermore preferably, the at least one device is illustrated in the graphical representation in the form of an image, which image is retrieved from an image database after the respective device has been identified.

According to a further preferred embodiment, a pre-processing step with a preliminary optical recognition of the at least one device is executed, wherein at least one feature of the at least one device is recognized, for example, a device type of the at least one device, or a manufacturer of the at least one device. Preferably, this is achieved by comparing the recorded visual representation of the device with device images or manufacturer logos or device type identifiers taken from an image database. In the pre-processing step, for example, OCR techniques may advantageously be used for extracting the manufacturer or model name from a logo, or generic optical recognition, like sub pattern matching, on just a logo, for example.

According to a further preferred embodiment , wherein a model of an arrangement of a plurality of devices arranged in a plurality of settings of a data centre is generated, the step (b) is executed at least once for each device and the step (c) is executed at least once for each setting.

The objective is as well achieved by system for generating a model of at least one device arranged in a setting of a data centre, which is adapted to execute the method according to the invention, as described before. The system according to the invention is described in claim 17.

The mobile device controller comprises at least one optical receiver. Each device comprises a light emitting and/or display means for emitting the identification signal. The identification signal received in step (b) is preferably stored in the data storage means. The mobile device controller is preferably connected to the network, particularly via a wireless connection.

The method and the system according to the invention will now be described together, with reference to an exemplary data centre depicted in the attached drawings. Embodiments of the method and the system according to the invention are realized therein and illustrated this way. The respective description refers to only one possible example for an implementation of the invention, and does not limit the scope of the inventive idea in any way.

In the Figures
Fig. 1 shows a schematic view of a data centre with an embodiment of the system according to the invention;
Fig. 2 shows another schematic view of the data centre according to Fig. 1 to illustrate an execution of the method according to the invention.

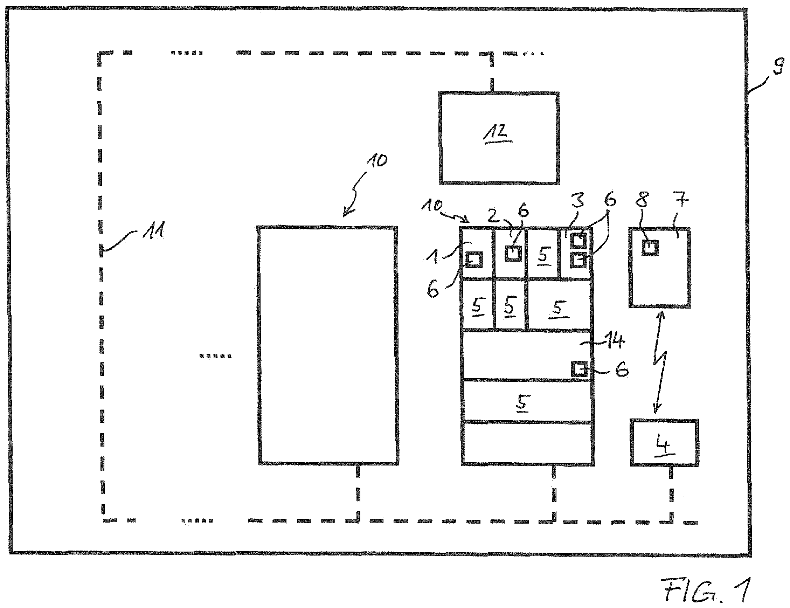

In Figure 1, a schematic view of a data centre 9 is depicted, wherein a method according to the invention is applicable and wherein an embodiment of the system according to the invention is comprised. The method of generating a model of an arrangement of at least one device arranged in a setting 10 of the data centre 9 will usually be applied with a plurality of devices 1, 2, 3, 14. In a first one of the settings 10, four devices 1, 2, 3, 14 are exemplarily denoted. The setting 10 is a general description of any kind of physically and locally defined receptacle, which in data centres is usually a metallic cage, typically called rack. Of course, there may be far more devices in this setting or rack 10, as well as in further settings 10. The existence of further settings 10 is indicated by the second setting 10, wherein the details of the second setting's contents have been omitted. The dotted line is meant to indicate the existence of further settings or racks with respective devices in the data centre 9. The devices 1, 2, 3, 14 are generally computer systems and other related components, for example, network switches, routers, uninterruptible power supplies etc. With reference numeral 5, non-occupied spaces are denoted, which may be equipped with further devices.

The illustrated embodiment of the system according to the invention comprises a network 11, the devices 1, 2, 3, 14 being connected to the network 11, one of them being a data storage means 14 capable of storing data, and a processing means 12 capable of processing data and generating an output, the processing means 12 running a central software and being connected to the network 11. The network 11 is schematically illustrated by a broken line, connecting the settings 10, the processing means 12 and further devices, which, of course, may all as well be regarded as devices of the data centre 9, of which a model is generated. The processing means 12 is illustrated as a stand-alone device here for reasons of accentuation, only, and may as well be located inside one of the racks 10, like the data storage means 14 is. It is understood, that the devices 1, 2, 3, 14 are connected to the network 11 via internal connections of the rack 10, which are not depicted.

The central software running on the processing means 12 is adapted to access the other devices 1, 2, 3, 14 and preferably also the racks 10, and to access an inventory of the devices of the data centre 9, for data centre management tasks. A mobile device controller 7 is connected to the network 11, for example via a wireless access point 4.

The system according to the invention is adapted to execute the method according to the invention, which with respect to the depicted embodiment comprises the steps of
- (a) sending a command to the devices 1, 2, 3, 14 upon which command the devices 1, 2, 3, 14 emit an identification signal, wherein the identification signal is receivable by the mobile device controller 7,
- (b) receiving the identification signal with the mobile device controller 7,
- (c) recording a visual representation of the arrangement of the devices 1, 2, 3, 14, particularly also with the mobile device controller 7,

- (d) identifying the devices 1, 2, 3, 14 according to the identification signal, particularly by the central software running on the processing means 12 and having access to the device inventory stored on the data storage means 14, and
- (e) providing the model comprising at least the following information: the identification of the devices 1, 2, 3, 14 and the arrangement of each device in the setting 10.

The mobile device controller 7 is adapted to receive the identification signal and to record the visual representation of the arrangement of the devices with respect to the setting 10. Therefore, the mobile device controller 7 comprises at least one optical receiver 8. The mobile device controller 7 is preferably a portable device with communication means and a camera or photo sensor, like a smartphone or a tablet PC. Each device 1, 2, 3, 14 comprises a light emitting and/or display means 6 for emitting the identification signal. The identification signal received in step (b) is preferably stored in the data storage means 14.

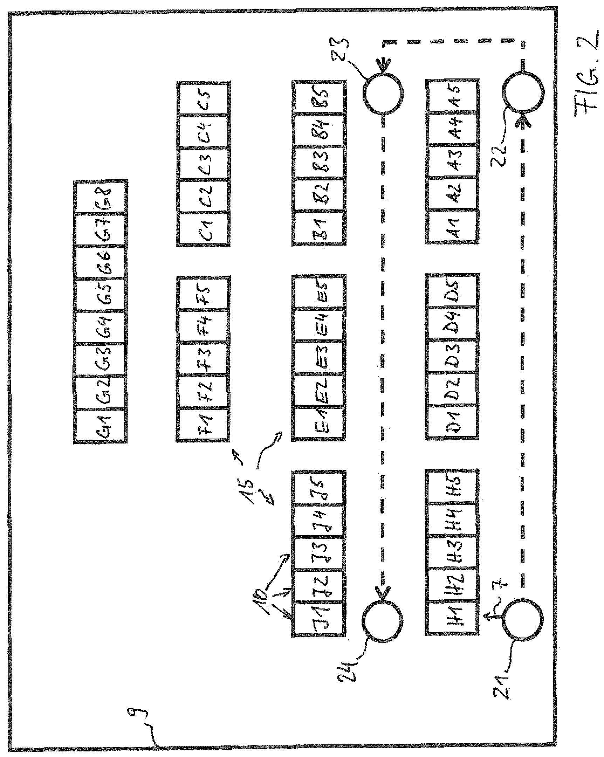

In Figure 2, another schematic view of the data centre 9 according to Fig. 1 is depicted to illustrate an execution of the method according to the invention. The data centre 9 comprises a plurality of cabinets 15, each with a plurality of racks 10, which are denoted with references A1, A2, etc, B1, B2, etc. through J1, J2 ... J5. The central software is ready to access devices in the data centre cabinets 15 and racks 10, respectively. An operator (not depicted) is equipped with the mobile device controller 7, and able to access the central software, through the network. The operator starts in the data centre 9 at an initial position, for example, point 21. Using the mobile device controller 7, the operator connects to the central software, a time synchronisation is done between the central software and the mobile device controller 7 and the operator initiates the step (a) for sending a command to the devices to emit an identification signal. For example, a sequence of the central software is started, stimulating the devices of one rack 10, like rack number HI, or stimulating the devices of one cabinet 15, comprising racks HI to H5, to emit the identification signal. The central software starts monitoring the devices' activities, that can cause visual activity, in order to emit a visual id signal, for example by blinking an LED. Stimulus sequences are generated on devices, to have LEDs or LCD screens blinking, for example, at a given frequency. These stimulus may be either direct, i.e. the commands are sent to make an LED blink, or indirect, through generating a load on the devices' CPU, HDD, etc., that will then cause a backplane LED to blink. The operator starts moving along the rows of cabinets 15, for example from point 21 to point 22, then from point 23 to point 24, and so on, with the mobile device controller 7 with the camera 8, for example automatically taking photos in burst mode or recording a video sequence, including timestamps.

The photos or the video sequence are time-stamped and sent to the central software for processing. The central software may process the retrieved pictures or video, for example, first in a pre-processing step with a preliminary optical recognition of the devices, such as OCR, for example, to determine a type of device, like a server, a storage device, etc., and pregroup the devices. The result of the pre-processing step may also be advantageously used to generate a smarter stimulation sequence in step (a). In the actual processing step (d) the timestamps are used by the central software for matching the stimulation sequences sent and the recorded activity of the devices with the visually received id signals as the counter-parts.

The steps of the method may be repeated several times, depending on the stimulation scope (data centre wide, limited to rows, cabinets 15 or racks 10) and depending on the matching processing results.

### Reference numerals

- 1: Device
- 2: Device
- 3: Device
- 4: Wireless access point
- 5: Unoccupied space
- 6: Light emitting means, display means
- 7: Mobile device controller
- 8: Optical receiver
- 9: Data centre
- 10: Setting, rack
- 11: Network
- 12: Processing means
- 14: Device, data storage means
- 15: Cabinet
- 21-24: Points

## Claims

1. Method of automatically generating a model of an arrangement of at least one device (1, 2, 3, 14) arranged in a setting (10) of a data centre (9), **characterised by** comprising the steps of
- (a) sending a command to the at least one device upon which command the device emits an identification signal, wherein the identification signal is receivable by a mobile device controller (7),
- (b) receiving the identification signal,
- (c) recording a visual representation of the arrangement of the at least one device,
- (d) identifying the at least one device according to the identification signal,
- (e) providing the model comprising at least the following information: the identification of the device (1, 2, 3, 14) and the arrangement of the device in the setting (10).

2. Method according to claim 1, wherein the identification signal is emitted in the form of a visual signal.

3. Method according to one of the preceding claims, wherein steps (b) and (c) are both executed by means of one optical receiver (8).

4. Method according to one of the preceding claims, wherein steps (b) and (c) are executed simultaneously.

5. Method according to one of the preceding claims, wherein the identification signal is emitted by light emitting and/or display means (6) of the device (1, 2, 3, 14).

6. Method according to one of the preceding claims, wherein the identification of the at least one device (1, 2, 3, 14) is encoded in the identification signal.

7. Method according to one of the preceding claims, wherein the identification signal received in step (b) is stored and the identification according to step (d) is executed subsequently, on the basis of the stored identification signal.

8. Method according to one of the preceding claims, wherein the identification signal received in step (b) is stored together with a timestamp comprising an information on a reception time of the identification signal.

9. Method according to one of the preceding claims, wherein at least a first execution of step (a) is triggered by the mobile device controller (7).

10. Method according to one of the preceding claims, wherein synchronously with a first execution of step ta), an activity monitoring of the at least one device (1, 2, 3, 14) is started.

11. Method according to claim 8, wherein the identification of the at least one device (1, 2, 3, 14) according to step (d) is executed by matching the timestamp of the stored identification signal with a monitored activity of the respective device at the reception time of the identification signal.

12. Method according to one of the preceding claims, wherein the model is provided with a graphical representation of the arrangement of the at least one device (1, 2, 3, 14) in the setting (10) on the basis of the recorded visual representation.

13. Method according to claim 12, wherein the at least one device (1, 2, 3, 14) is illustrated in the graphical representation in the form of an image, which image is retrieved from an image database after the respective device has been identified.

14. Method according to one of the preceding claims, wherein the model is provided in a data format processible by a data centre management software.

15. Method according to one of the preceding claims, further comprising a pre-processing step with a preliminary optical recognition of the at least one device (1, 2, 3, 14), wherein at least one feature of the at least one device is recognized.

16. Method according to one of the preceding claims, wherein a model of an arrangement of a plurality of devices (1, 2, 3, 14) arranged in a plurality of settings (10) of a data centre (9) is generated, wherein the step (b) is executed at least once for each device and the step (c) is executed at least once for each setting.

17. System for generating a model of of an arrangement of at least one device (1, 2, 3, 14) arranged in a setting (10) of a data centre (9), wherein the system is adapted to execute the method of any one of the preceding claims and comprises:
a network (11), the at least one device being connected to the network,
a data storage means (14) capable of storing data and connected to the network,
a processing means (12) capable of processing data and generating an output, the processing means running a central software and being connected to the network,
the central software being adapted to access the at least one device (1, 2, 3, 14) and to access an inventory of devices stored on the data storage means (14),
and a mobile device controller (7) connected to the network, the mobile device controller being adapted to receive the identification signal and record the visual representation of the arrangement of the at least one device with respect to the setting,
wherein the system is adapted to execute the following steps:
- (a) sending a command to the at least one device upon which command the device emits an identification signal, wherein the identification signal is receivable by the mobile device controller (7),
- (b) receiving the identification signal,
- (c) recording a visual representation of the arrangement of the at least one device,
- (d) identifying the at least one device according to the identification signal, particularly by the central software running on the processing means (12) and having access to the device inventory stored on the data storage means (14), and
- (e) providing the model comprising at least the following information: the identification of the device (1, 2, 3, 14) and the arrangement of the device in the setting (10).

## Patentansprüche

1. Verfahren zum automatischen Erzeugen eines Modells einer Anordnung mindestens eines Geräts (1, 2, 3, 14), das in einer Umgebung (10) eines Rechenzentrums (9) angeordnet ist, **dadurch gekennzeichnet, dass** es die folgenden Schritte umfasst
- (a) Senden eines Befehls an das mindestens eine Gerät, wobei das Gerät auf diesen Befehl hin ein Identifikationssignal aussendet, wobei das Identifikationssignal von einer Mobilgerätesteuerung (7) empfangbar ist,
- (b) Empfangen des Identifikationssignals,
- (c) Aufzeichnen einer visuellen Darstellung der Anordnung des mindestens einen Geräts,
- (d) Identifizieren des mindestens einen Geräts nach dem Identifizierungssignal,
- (e) Bereitstellen des Modells, das mindestens die folgenden Informationen umfasst: die Identifikation des Geräts (1, 2, 3, 14) und die Anordnung des Geräts in der Umgebung (10).

2. Verfahren nach Anspruch 1, wobei das Identifikationssignal in Form eines optischen Signals abgegeben wird.

3. Verfahren nach einem der vorstehenden Ansprüche, wobei die Schritte (b) und (c) beide mittels eines optischen Empfängers (8) ausgeführt werden.

4. Verfahren nach einem der vorstehenden Ansprüche, wobei die Schritte (b) und (c) gleichzeitig ausgeführt werden.

5. Verfahren nach einem der vorstehenden Ansprüche, wobei das Identifikationssignal von lichtemittierenden Mitteln und/oder Anzeigemitteln (6) des Geräts (1, 2, 3, 14) abgegeben wird.

6. Verfahren nach einem der vorstehenden Ansprüche, wobei die Identifikation des mindestens einen Gerät (1, 2, 3, 14) im Identifikationssignal kodiert wird.

7. Verfahren nach einem der vorstehenden Ansprüche, wobei das in Schritt (b) empfangene Identifikationssignal gespeichert und die Identifikation nach Schritt (d) anschließend auf der Grundlage des gespeicherten Identifikationssignals ausgeführt wird.

8. Verfahren nach einem der vorstehenden Ansprüche, wobei das in Schritt (b) empfangene Identifikationssignal zusammen mit einem Zeitstempel gespeichert wird, der eine Information über eine Empfangszeit des Identifikationssignals umfasst.

9. Verfahren nach einem der vorstehenden Ansprüche, wobei mindestens eine erste Ausführung von Schritt (a) durch die Mobilgerätesteuerung (7) ausgelöst wird.

10. Verfahren nach einem der vorstehenden Ansprüche, wobei synchron mit einer ersten Ausführung von Schritt (a) eine Aktivitätsüberwachung des mindestens einen Geräts (1, 2, 3, 14) gestartet wird.

11. Verfahren nach Anspruch 8, wobei die Identifikation des mindestens einen Geräts (1, 2, 3, 14) nach Schritt (d) durchgeführt wird, durch zuordnen des Zeitstempels des gespeicherten Identifikationssignals zu einer überwachten Aktivität des jeweiligen Geräts zum Empfangszeitpunkt des Identifikationssignals.

12. Verfahren nach einem der vorstehenden Ansprüche, wobei das Modell mit einer grafischen Darstellung der Anordnung des mindestens einen Geräts (1, 2, 3, 14) in der Umgebung (10) auf der Grundlage der aufgezeichneten visuellen Darstellung bereitgestellt ist.

13. Verfahren nach Anspruch 12, wobei das mindestens eine Gerät (1, 2, 3, 14) in der grafischen Darstellung in Form eines Bildes dargestellt wird, wobei das Bild aus einer Bilddatenbank abgerufen wird, nachdem das jeweilige Gerät identifiziert wurde.

14. Verfahren nach einem der vorstehenden Ansprüche, wobei das Modell in einem Datenformat bereitgestellt wird, das von einer Rechenzentrumsverwaltungssoftware verarbeitet werden kann.

15. Verfahren nach einem der vorstehenden Ansprüche, ferner umfassend einen Vorverarbeitungsschritt mit einer vorläufigen optischen Erkennung des mindestens einen Geräts (1, 2, 3, 14), wobei mindestens ein Merkmal des mindestens einen Geräts erkannt wird.

16. Verfahren nach einem der vorstehenden Ansprüche, wobei ein Modell einer Anordnung aus einer Vielzahl von Geräten (1, 2, 3, 14), die in einer Vielzahl von Umgebungen (10) eines Rechenzentrums (9) angeordnet sind, erzeugt wird, wobei der Schritt (b) mindestens einmal für jedes Gerät ausgeführt wird und der Schritt (c) mindestens einmal für jede Umgebung ausgeführt wird.

17. System zum Erzeugen eines Modells einer Anordnung von mindestens einem Gerät (1, 2, 3, 14), die in einer Umgebung (10) eines Rechenzentrums (9) angeordnet ist, wobei das System dazu eingerichtet ist, das Verfahren eines der vorhergehenden Ansprüche auszuführen, und umfasst:
ein Netzwerk (11), wobei das mindestens eine Gerät mit dem Netzwerk verbunden ist,
ein Datenspeichermittel (14), das in der Lage ist, Daten zu speichern und mit dem Netzwerk verbunden ist,
ein Verarbeitungsmittel (12), das in der Lage ist, Daten zu verarbeiten und eine Ausgabe zu erzeugen, wobei das Verarbeitungsmittel eine zentrale Software betreibt und mit dem Netzwerk verbunden ist,
wobei die zentrale Software dazu eingerichtet ist, um auf das mindestens eine Gerät (1, 2, 3, 14) zuzugreifen und auf ein Verzeichnis der auf dem Datenspeichermittel (14) gespeicherten Geräte zuzugreifen,
und eine Mobilgerätesteuerung (7), die mit dem Netzwerk verbunden ist,
wobei die Mobilgerätesteuerung angepasst ist, um das Identifikationssignal zu empfangen und die visuelle Darstellung der Anordnung des mindestens einen Geräts in Bezug auf die Umgebung aufzuzeichnen,
wobei das System angepasst ist, um die folgenden Schritte auszuführen:
- (a) Senden eines Befehls an das mindestens eine Gerät, wobei auf diesen Befehl hin das Gerät ein Identifikationssignal aussendet, wobei das Identifikationssignal von der Mobilgerätesteuerung (7) empfangbar ist,
- (b) Empfangen des Identifikationssignals,
- (c) Aufzeichnen einer visuellen Darstellung der Anordnung des mindestens einen Geräts,
- (d) Identifizieren des mindestens einen Geräts nach dem Identifikationssignal, insbesondere durch die auf dem Verarbeitungsmittel (12) laufende zentrale Software, die Zugang zu dem auf dem Datenspeichermittel (14) gespeicherten Gerätsinventar hat, und
- (e) Bereitstellen des Modells, das mindestens die folgenden Informationen umfasst: die Identifikation des Geräts (1, 2, 3, 14) und die Anordnung des Geräts in der Umgebung (10).

## Revendications

1. Procédé de génération automatique d'un modèle d'un agencement d'au moins un dispositif (1, 2, 3, 14) agencé dans une configuration (10) d'un centre de données (9) **caractérisé en ce qu'**il comprend les étapes suivantes :
- (a) envoi d'une commande à l'au moins un dispositif sur laquelle commande le dispositif émet un signal d'identification, dans lequel le signal d'identification peut être reçu par une unité de commande de dispositif mobile (7),
- (b) réception du signal d'identification,
- (c) enregistrement d'une représentation visuelle de l'agencement de l'au moins un dispositif,
- (d) identification de l'au moins un dispositif selon le signal d'identification,
- (e) fourniture du modèle comprenant au moins les informations suivantes : l'identification du dispositif (1, 2, 3, 14) et l'agencement du dispositif dans la configuration.

2. Procédé selon la revendication 1, dans lequel le signal d'identification est émis sous la forme d'un signal visuel.

3. Procédé selon l'une des revendications précédentes, dans lequel les étapes (b) et (c) sont toutes deux exécutées au moyen d'un récepteur optique (8).

4. Procédé selon l'une des revendications précédentes, dans lequel les étapes (b) et (c) sont exécutées de manière simultanée.

5. Procédé selon l'une des revendications précédentes, dans lequel le signal d'identification est émis par un moyen d'émission de lumière et/ou d'affichage (6) du dispositif (1, 2, 3, 14).

6. Procédé selon l'une des revendications précédentes, dans lequel l'identification de l'au moins un dispositif (1, 2, 3, 14) est codée dans le signal d'identification.

7. Procédé selon l'une des revendications précédentes, dans lequel le signal d'identification reçu à l'étape (b) est stocké et l'identification selon l'étape (d) est exécutée ensuite, sur la base du signal d'identification stocké.

8. Procédé selon l'une des revendications précédentes, dans lequel le signal d'identification reçu à l'étape (b) est stocké conjointement avec une estampille temporelle comprenant une information sur une heure de réception du signal d'identification.

9. Procédé selon l'une des revendications précédentes, dans lequel au moins une première exécution de l'étape (a) est déclenchée par une unité de commande de dispositif mobile (7).

10. Procédé selon l'une des revendications précédentes, dans lequel en synchronisation avec une première exécution de l'étape (a), une surveillance d'activité de l'au moins un dispositif (1, 2, 3, 14) est démarrée.

11. Procédé selon la revendication 8, dans lequel l'identification de l'au moins un dispositif (1, 2, 3, 14) selon l'étape (d) est exécutée en faisant correspondre l'estampille temporelle du signal d'identification stocké avec une activité surveillée du dispositif respectif au moment de réception du signal d'identification.

12. Procédé selon l'une des revendications précédentes, dans lequel le modèle est pourvu d'une représentation graphique de l'agencement de l'au moins un dispositif (1, 2, 3, 14) dans la configuration (10) sur la base de la représentation visuelle enregistrée.

13. Procédé selon la revendication 12, dans lequel l'au moins un dispositif (1, 2, 3, 14) est illustré dans la représentation graphique sous la forme d'une image, laquelle image est récupérée à partir d'une base de données d'images une fois que le dispositif respectif a été identifié.

14. Procédé selon l'une des revendications précédentes, dans lequel le modèle est prévu dans un format de données pouvant être traité par un logiciel de gestion de centre de données.

15. Procédé selon l'une quelconque des revendications précédentes, comprenant en outre une étape de prétraitement avec une reconnaissance optique préliminaire de l'au moins un dispositif (1, 2, 3, 14), dans lequel au moins une caractéristique de l'au moins un dispositif est reconnue.

16. Procédé selon l'une des revendications précédentes, dans lequel un modèle d'un agencement d'une pluralité de dispositifs (1, 2, 3, 14) agencés dans une pluralité de configurations (10) d'un centre de données (9) est généré, dans lequel l'étape (b) est exécutée au moins une fois pour chaque dispositif et l'étape (c) est exécutée au moins une fois pour chaque configuration.

17. Système pour générer un modèle d'un agencement d'au moins un dispositif (1, 2, 3, 14) agencé dans une configuration (10) d'un centre de données (9), dans lequel le système est adapté pour exécuter le procédé de l'une quelconque des revendications précédentes et comprend :
un réseau (11), l'au moins un dispositif étant connecté au réseau,
un moyen de stockage de données (14) capable de stocker des données et connecté au réseau,
un moyen de traitement (12) capable de traiter des données et de générer une sortie, le moyen de traitement exécutant un logiciel central et étant connecté au réseau, le logiciel central étant adapté pour accéder à l'au moins un dispositif (1, 2, 3, 14) et pour accéder à un inventaire de dispositifs stockés sur le moyen de stockage de données (14),
et une unité de commande de dispositif mobile (7) connectée au réseau, l'unité de commande de dispositif mobile étant adaptée pour recevoir le signal d'identification et enregistrer la représentation visuelle de l'agencement de l'au moins un dispositif par rapport à la configuration, dans lequel le système est adapté pour exécuter les étapes suivantes :
- (a) envoi d'une commande à l'au moins un dispositif sur laquelle commande le dispositif émet un signal d'identification, dans lequel le signal d'identification peut être reçu par une unité de commande de dispositif mobile (7),
- (b) réception du signal d'identification,
- (c) enregistrement d'une représentation visuelle de l'agencement de l'au moins un dispositif,
- (d) identification de l'au moins un dispositif selon le signal d'identification, en particulier par le logiciel central exécuté sur le moyen de traitement (12) et ayant accès à l'inventaire de dispositifs stocké sur le moyen de stockage de données (14), et
- (e) fourniture du modèle comprenant au moins les informations suivantes : l'identification du dispositif (1, 2, 3, 14) et l'agencement du dispositif dans la configuration (10).
